# EUROPÄISCHE PATENTSCHRIFT

(11) **EP 2 662 894 B1**
(45) Veröffentlichungstag und Bekanntmachung des Hinweises auf die Patenterteilung: **04.03.2015**
(21) Anmeldenummer: 13166344.5
(22) Anmeldetag: 03.05.2013
(51) Int. Cl.: H01L 25/075, F21K 99/00, H01L 33/60, F21Y 105/00, H01L 33/62

(54) **Leuchtdiodenanordnung insbesondere zu Beleuchtungszwecken und Verfahren zur Herstellung einer Leuchtdiodenanordnung**
Light-emitting diode arrangement, in particular for illumination purposes and method for producing an arrangement of light emitting diodes
Agencement de diodes lumineuses notamment à des fins d'éclairage et procédé de fabrication d'un agencement de diodes lumineuses

(30) Priorität: 07.05.2012 DE 102012103983
(43) Veröffentlichungstag der Anmeldung: 13.11.2013
(73) Patentinhaber: Vossloh-Schwabe Optoelektronik GmbH & Co. KG, 47475 Kamp Lintfort (DE)
(72) Erfinder: Kwetkat, Stefan, 46487 Wesel (DE); Wilsberg, Andreas, 50374 Erftstadt (DE); Depke, Jan Thomas, 47443 Moers (DE); Thormann, Tobias, 46569 Hünxe (DE)
(74) Vertreter: Rüger, Barthelt & Abel

(56) Entgegenhaltungen:
- US-A1- 2009 010 009
- US-A1- 2011 299 268

## Beschreibung

Die Erfindung betrifft eine Leuchtdiodenanordnung, insbesondere zur Beleuchtungszwecken, sowie ein Verfahren zu deren Herstellung.

Bei Leuchtdioden für Beleuchtungszwecke ist häufig ein Träger oder Reflektor mit kreisförmiger Kontur vorhanden. In der Regel werden Leuchtdioden auf einem Träger, etwa einer Leiterplatte oder einem Reflektor in Form einer rechteckigen Matrix angeordnet und elektrisch miteinander verbunden. Die Leuchtdioden erhalten einen sogenannten Volumenverguss mit einem darin enthaltenen Leuchtstoff über alle Diodenchips. Trotz dieses durchgängigen Volumenvergusses kann es in den Randzonen zwischen der matrixförmigen Anordnung der Diodenchips und dem kreisförmigen Rand eines umgebenden Reflektorkörpers zu dunkleren Zonen kommen, was unerwünscht ist.

US 2011/299268 A1 offenbart eine gattungsgemäße Leuchtdiodenanordnung mit mehreren Leuchtdiodengruppen. Jede Leuchtdiodengruppe weist mehrere in Reihe geschaltete Leuchtdioden auf. Die Leuchtdioden einer Leuchtdiodengruppe in zwei parallelen Reihen abwechselnd angeordnet, so dass die,Reihenschaltung einer Leuchtdiodengruppe sozusagen eine Zickzackanordnung darstellt.

Aus US 2009/0010009 A1 ist eine Leuchtdiodenanordnung bekannt. Dabei können die Leuchtdioden in mehrere Leuchtdiodengruppen unterteilt sein. Jede Leuchtdiodengruppe besteht bei einem Ausführungsbeispiel aus mehreren Leuchtdioden, die in V-Form auf einem Träger angeordnet sind. Alternativ hierzu ist auch vorgeschlagen, die Leuchtdioden in parallel zueinander verlaufenden Reihen auf dem Träger anzuordnen.

Ausgehend vom Stand der Technik kann es als eine Aufgabe der vorliegenden Erfindung angesehen werden, eine Leuchtdiodenanordnung zu schaffen, die dunklere Randzonen zu einem kreisförmigen Reflektorkörper vermeidet oder minimiert und die sich außerdem sehr einfach durch vorhandene Vorrichtungen und Maschinen herstellen lässt.

Diese Aufgabe wird durch eine Leuchtdiodenanordnung mit den Merkmalen des Patentanspruches 1 sowie ein Verfahren mit den Merkmalen des Patentanspruches 12 gelöst.

Die Leuchtdiodenanordnung weist mehrere Leuchtdioden auf, die in mehrere Leuchtdiodengruppen mit vorzugsweise jeweils gleicher Anzahl von Leuchtdioden aufgeteilt sind. Die Leuchtdioden weisen jeweils einen vorzugsweise rechteckigen Diodenchip mit einer Anodenkontaktfläche und einer Kathodenkontaktfläche auf. Wenigstens eine der Kontaktflächen und vorzugsweise beide Kontaktflächen sind außermittig außen am Diodenchip angeordnet. Die Kontur der beiden Kontaktflächen ist vorzugsweise verschieden. Durch die Kontaktflächen kann ein eindeutiges Orientierungsmerkmal des Diodenchips gegeben sein. Die Leuchtdiodengruppen sind auf einem gemeinsamen Träger, insbesondere einem Reflektor angeordnet. Der Träger kann die Kontur eines vorzugsweise regelmäßigen Polygons, beispielsweise eines Sechsecks aufweisen. Das Polygon hat insbesondere zumindest fünf Ecken. Die Form ist dadurch besser einer kreisrunden Form angenähert. Es ist dadurch möglich, einen weiteren Reflektorkörper mit einer kreisrunden Öffnung um den Träger herum anzuordnen, wobei nur kleine Randzonen verbleiben, in denen keine Leuchtdiode angeordnet ist.

Ein Richtungsvektor definiert die Orientierung der Diodenchips um eine Hochachse, die rechtwinkelig zum Träger orientiert ist. Der Richtungsvektor kann durch eine Projektion eines Vektors von der Anodenkontaktfläche zur Kathodenkontaktfläche in die Ebene des Trägers gebildet sein. Vorzugsweise sind die Anodenkontaktfläche und die Kathodenkontaktfläche in einer gemeinsamen Ebene auf der Außenfläche des Diodenchips angeordnet. Die Orientierung des Diodenchips ist entscheidend für eine einfache Herstellung der Leuchtdiodenanordnung, beispielsweise beim Aufbringen eines Leuchtstoffes auf die Diodenchips oder beim Anbringen von Bonddrähten an den Kontaktflächen, insbesondere wenn die Diodenchips gemäß der Erfindung nicht in einer rechteckigen Matrix angeordnet sind.

Ein Teil der Diodenchips einer Leuchtdiodengruppe bildet eine Winkelanordnung auf dem Träger. Die Diodenchips sind dabei entlang einer abgewinkelten Linie angeordnet. Mit anderen Worten wird eine vorzugsweise ungerade Anzahl von Diodenchips entlang zweier sich schneidender Geraden angeordnet, wobei sich der mittlere Diodenchip an oder am nächsten zu der Spitze dieser abgewinkelten Linie bzw. am Schnittpunkt der Geraden befindet. Der Richtungsvektor dieses mittleren Diodenchips verläuft rechtwinklig zu einer Winkelhalbierenden durch die Spitze der abgewinkelten Linie. Alle Diodenchips einer gemeinsamen Winkelanordnung sind elektrisch in Reihe geschaltet. Die elektrische Verbindung zwischen den Diodenchips einer Winkelanordnung wird zumindest teilweise mit Hilfe von Bonddrähten durchgeführt.

Vorzugsweise ist der Träger zumindest im Bereich der Chips frei von Leiterbahnen. Alle elektrischen Verbindungen zwischen den Diodenchips können durch Bonddrähte hergestellt sein. Die Anodenkontaktfläche und die Kathodenkontaktfläche befinden sich insbesondere auf der dem Träger abgewandten Oberseite der Diodenchips. Durch die erfindungsgemäße Orientierung des mittleren Diodenchips können mit herkömmlichen Bondmaschinen in einem einfachen Prozess die beiden Teile der Winkelanordnung, die sich linear zur Spitze der abgewinkelten Linie hin erstrecken, elektrisch miteinander verbunden werden. Für das Anbringen der Bonddrähte zwischen den einzelnen Diodenchips ist die Orientierung der Diodenchips wichtig, um das Herstellungsverfahren so einfach wie möglich zu halten und mit herkömmlichen Vorrichtungen zu ermöglichen. Die erfindungsgemäße Orientierung bietet die Möglichkeit, mehrere Winkelanordnungen von Diodenchips in einer einzelnen Leuchtdiodengruppe und wiederum mehrere solcher Leuchtdiodengruppen zu realisieren und dabei eine hohe Symmetrie der Anordnung der Leuchtdioden auf dem Träger zu erreichen. Diese Symmetrie ist für die Abstrahlcharakteristik des Lichts entscheidend.

Im Folgenden werden vorteilhafte Ausführungsformen der Erfindung beschrieben.

Eine vorteilhafte Ausführung der vorliegenden Erfindung betrifft eine Leuchtdiodenanordnung mit einem Träger, insbesondere Reflektor, der mit einer Leiterplatte verbunden ist. Auf dem Träger sind mehrere Leuchtdiodengruppen mit jeweils mehreren Leuchtdioden angeordnet. Jede Leuchtdiodengruppe weist wenigstens eine Reihenschaltung auf, die insbesondere, wie im Zusammenhang mit dem ersten Aspekt der Erfindung beschrieben, als Winkelanordnung von Diodenchips ausgeführt sein kann. Für jede Leuchtdiodengruppe ist auf der Leiterplatte ein Anschlussbereich mit mehreren Anschlussleiterbahnen vorhanden. Vorzugsweise ist jeder Seitenkante des Trägers ein Anschlussbereich zugeordnet. Wenigstens zwei Ansteuerleiterbahnen laufen um die Anschlussbereiche bzw. um den Träger herum.

Die elektrischen Verbindungen zwischen den Anschlussleiterbahnen und den Ansteuerleiterbahnen sind nur zum Teil durch Leiterbahnen auf der Leiterplatte realisiert. Jeder Anschlussbereich ist darüber hinaus mit zumindest einem Bonddraht mit wenigstens einer der Anschlussleiterbahnen elektrisch verbunden. Die elektrische Verbindung zwischen den Anschlussbereichen und den Leuchtdiodengruppen erfolgt ebenfalls über wenigstens einen Bonddraht. Auf diese Weise können unterschiedliche elektrische Schaltungen der Leuchtdioden auf sehr einfache Weise hergestellt werden. Mit demselben Leiterplattenlayout lassen sich daher sehr einfach unterschiedliche Schaltungsvarianten herstellen. Die Varianten können dadurch entstehen, dass unterschiedliche Anschlusspunkte im Anschlussbereich mit verschiedenen möglichen Anschlüssen an den Ansteuerleiterbahnen verbunden werden. So kann beispielsweise die Anzahl der parallel bzw. in Reihe geschalteten Leuchtdioden einer Leuchtdiodengruppe variiert werden, ohne dass hierfür eine Änderung des Layouts der Leiterplatte notwendig wäre. Da die Diodenchips ohnehin über Bonddrähte untereinander und mit dem Anschlussbereich verbunden werden, ist der zusätzliche Herstellungsaufwand für die unterschiedlichen Schaltungsvarianten gering. Lötbrücken, Durchkontaktierungen oder ähnliches sind nicht notwendig.

Jede Leuchtdiodengruppe weist mehrere Winkelanordnungen von Diodenchips auf, wobei die Winkelanordnungen einer Leuchtdiodengruppe jeweils unterschiedlich viele Diodenchips aufweisen. Bei dieser Ausführung werden zwei oder auch mehre Winkelanordnungen zu einer Reihenschaltung elektrisch verbunden. Die Leuchtdiodengruppe weist zwei oder mehr solcher Reihenschaltungen auf, die jeweils die gleiche Anzahl von Diodenchips aufweisen. Durch diese Anordnung lässt sich durch mehrere Winkelanordnungen eine dreieckförmige Leuchtdiodengruppe aufbauen. Eine solche dreieckförmige Leuchtdiodengruppe hat den Vorteil, dass eine Kombination von mehreren dreieckförmigen Leuchtdiodengruppen in sehr viele unterschiedliche Flächenformen des Trägers eingepasst werden können.

Bei einem erfindungsgemäßen Ausführungsbeispiel der Leuchtdiodenanordnung verlaufen alle Richtungsvektoren aller Diodenchips derselben Winkelanordnung oder derselben Leuchtdiodengruppe parallel und/oder antiparallel zueinander. Insbesondere sind die Richtungsvektoren so orientiert, dass die parallel zu einer zugeordneten Seitenkante des Trägers verlaufen, an der sich der Anschlussbereich für diese Leuchtdiodengruppe befindet. Dies vereinfacht das Bestücken des Trägers mit den Diodenchips.

Bei einer anderen erfindungsgemäßen Ausführungsform ist der Richtungsvektor des mittleren Diodenchips an oder am nächsten zu der Spitze der wenigstens einen abgewinkelten Linie anders orientiert als die Richtungsvektoren der anderen Diodenchips entlang der abgewinkelten Linie.

Dabei ist der Richtungsvektor des mittleren Diodenchips rechtwinklig zur Winkelhalbierenden durch die abgewinkelte Linie orientiert, während die Richtungsvektoren aller anderen Diodenchips in Richtung der Winkelhalbierenden zeigen. Bei dieser Anordnung können mehrere Winkelanordnungen einer Leuchtdiodengruppe sehr dicht nebeneinander angeordnet werden, wobei der Abstand der Diodenchips verschiedener Winkelanordnungen noch ausreichend groß ist, um eine einfache optische Entkopplung benachbarter Leuchtdioden d.h. Winkelanordnungen - zu gewährleisten.

Die Anzahl der Leuchtdiodengruppen entspricht vorzugsweise der Anzahl der Seitenkanten des polygonalen Trägers, insbesondere Reflektors. Zur Erzielung einer hohen Symmetrie sind die einzelnen Leuchtdiodengruppen derart positioniert und orientiert, dass sich die Position und Orientierung der Diodenchips einer beliebigen Leuchtdiodengruppe durch Drehung einer der anderen Leuchtdiodengruppen um eine rechtwinklig zum Träger durch dessen Mittelpunkt verlaufende Hochachse ergibt. Eine solche Anordnung ermöglicht die Bestückung des Trägers mit Diodenchips durch herkömmliche Vorrichtungen und ergibt eine symmetrische Abstrahlcharakteristik gegenüber der optischen Achse der Leuchtdiodenanordnung.

Jedem Diodenchip einer Leuchtdiode ist ein Leuchtstoffkörper zugeordnet. Dabei kann jeder Diodenchip einen separaten Leuchtstoffkörper aufweisen. Alternativ hierzu besteht auch die Möglichkeit, einen linienförmigen Leuchtstoffkörper herzustellen, dem mehrere Diodenchips zugeordnet sind. In diesem Fall weisen mehrere Leuchtdioden einen gemeinsamen Leuchtstoffkörper auf. Es ist insbesondere zweckmäßig, wenn alle Richtungsvektoren der Diodenchips, die einem gemeinsamen Leuchtstoffkörper zugeordnet sind, parallel oder antiparallel ausgerichtet sind.

Bei einer bevorzugten Ausführungsform enthält jede Leuchtdiodengruppe wenigstens eine erste und wenigstens eine zweite Leuchtdiode. Die erste Leuchtdiode strahlt Licht mit einer ersten Lichtfarbe oder einer ersten Farbtemperatur und die zweite Leuchtdiode strahl Licht mit einer von der ersten Lichtfarbe oder der ersten Farbtemperatur verschiedenen zweiten Lichtfarbe oder zweiten Farbtemperatur ab. Mit verschiedenen Lichtfarben ist gemeint, dass sich das Spektrum des abgestrahlten Lichts der ersten und der zweiten Leuchtdiode unterscheidet. Beispielsweise haben die Spektren der ersten und der zweiten Lichtfarbe unterschiedliche Schwerpunktwellenlängen.

Um unterschiedliche Lichtfarben oder Farbtemperaturen zu erreichen weist beispielsweise die erste Leuchtdiode einen ersten Leuchtstoffköper und die zweite Leuchtdiode einen zweiten Leuchtstoffkörper auf. Die beiden Leuchtstoffkörper enthalten unterschiedliche Leuchtstoffe und/oder Leuchtstoffe in unterschiedlicher Konzentration, so dass sie bei der Anregung durch den jeweils zugeordneten wenigstens einen Diodenchip Licht mit unterschiedlichen Lichtfarben oder Farbtemperaturen emittieren. Insbesondere sind die ersten Leuchtdioden und die zweiten Leuchtdioden einer Leuchtdiodengruppe separat voneinander ansteuerbar, so dass sich die von der Leuchtdiodenanordnung abgestrahlte Lichtfarbe oder Farbtemperatur in einem Bereich zwischen der ersten Lichtfarbe oder Farbtemperatur und der zweiten Lichtfarbe oder Farbtemperatur einstellen lässt. Die erste Farbtemperatur entspricht vorzugsweise einem Kaltweiß und die zweite Farbtemperatur entspricht vorzugsweise einem Warmweiß.

Insbesondere gehören die wenigstens eine erste Leuchtdiode und die wenigstens eine zweite Leuchtdiode zu unterschiedlichen Winkelanordnungen und insbesondere zu unterschiedlichen Reihenschaltungen einer gemeinsamen Leuchtdiodengruppe. Bevorzugt sind die Winkelanordnungen einer Leuchtdiodengruppe abwechselnd aus ersten Leuchtdioden und zweiten Leuchtdioden gebildet.

Um ein unerwünschtes Mischen der ersten Lichtfarbe bzw. Farbtemperatur und der zweiten Lichtfarbe bzw. Farbtemperatur zu vermeiden, ist der erste Leuchtstoffkörper der wenigstens einen ersten Leuchtdiode optisch von dem zweiten Leuchtstoffkörper der wenigstens einen zweiten Leuchtdiode entkoppelt oder getrennt. Die optische Trennung bedeutet, dass das von der wenigstens einen ersten Leuchtdiode emittierte Licht nicht in den zweiten Leuchtstoffkörper der wenigstens einen zweiten Leuchtdiode einkoppelt und umgekehrt. Sonst könnte eine unerwünschte Anregung des Leuchtstoffs des ersten und des zweiten Leuchtstoffkörpers über einen Diodenchip verursacht werden, so dass eine ungewollte Lichtmischung stattfindet. Um eine gezielte Farbjustierung im Bereich zwischen der ersten Lichtfarbe oder der ersten Farbtemperatur und der zweiten Lichtfarbe oder der zweiten Farbtemperatur zu ermöglichen, sind die beiden Leuchtstoffkörper voneinander optisch getrennt. Dies kann beispielsweise durch einen ausreichenden Abstand zwischen den einzelnen Diodenchips bzw. den Leuchtstoffkörpern und/oder durch ein zwischen benachbarten Diodenchips oder Leuchtstoffkörpern angeordnetes optisches Trennmittel erfolgen.

Der Träger weist bevorzugt eine spiegelnde oder diffus reflektierende Oberfläche auf. Bei einem Ausführungsbeispiel besteht der Träger bzw. Reflektor aus Aluminium. Dadurch wird gleichzeitig eine gute Wärmeableitung von den Diodenchips in der Trägerebene erreicht. Mit dem Träger kann ein Kühlkörper zur Wärmeabfuhr verbunden sein. Der Träger erstreckt sich beispielsgemäß in einer Ebene und hat eine plattenförmige Gestalt.

Die erfindungsgemäße Leuchtdiodenanordnung lässt sich sehr einfach herstellen. Insbesondere kann das Bestücken des Reflektors mit Diodenchips über einen herkömmlichen um eine Vertikalachse schwenkbaren Greifer erfolgen, der die Diodenchips von einem Wafer aufnimmt, der auf einem horizontal verschiebbaren Tisch gelagert ist. Der Greifer positioniert die Diodenchips dann auf dem Reflektor, der in einer horizontal verschiebbaren Aufnahme gehalten ist.

Vorteilhafte Ausgestaltungen der Erfindung ergeben sich aus den abhängigen Patentansprüchen und der Beschreibung. Die Zeichnung ist ergänzend heranzuziehen. Die Beschreibung beschränkt sich auf wesentliche Merkmale der Erfindung sowie sonstiger Gegebenheiten. Im Folgenden werden Ausführungsbeispiele der Erfindung anhand der beigefügten Zeichnung erläutert. Es zeigen:
Figur 1 eine schematische Darstellung eines Ausführungsbeispiels einer Leuchtdiode mit einem kalottenförmigen Leuchtstoffkörper,
Figuren 2 und 3 jeweils eine schematische Darstellung einer ersten Leuchtdiode und einer benachbarten zweiten Leuchtdiode in der Form nach Figur 1, die optisch voneinander getrennt sind,
Figur 4 ein Ausführungsbeispiel für die Anordnung der Diodenchips der Leuchtdioden auf einem Reflektor und eine mit dem Reflektor verbundene Leiterplatte in Draufsicht,
Figur 5 eine vergrößerte Darstellung einer der Leuchtdiodengruppen der Diodenchips gemäß Figur 4,
Figur 6 eine alternative Anordnungsmöglichkeit der Diodenchips einer Leuchtdiodengruppe zur Bestückung des Reflektors gemäß Figur 4 und
Figur 7 eine schematische Darstellung einer Vorrichtung zur Bestückung des Reflektors mit Diodenchips für das anschließende Bonden.

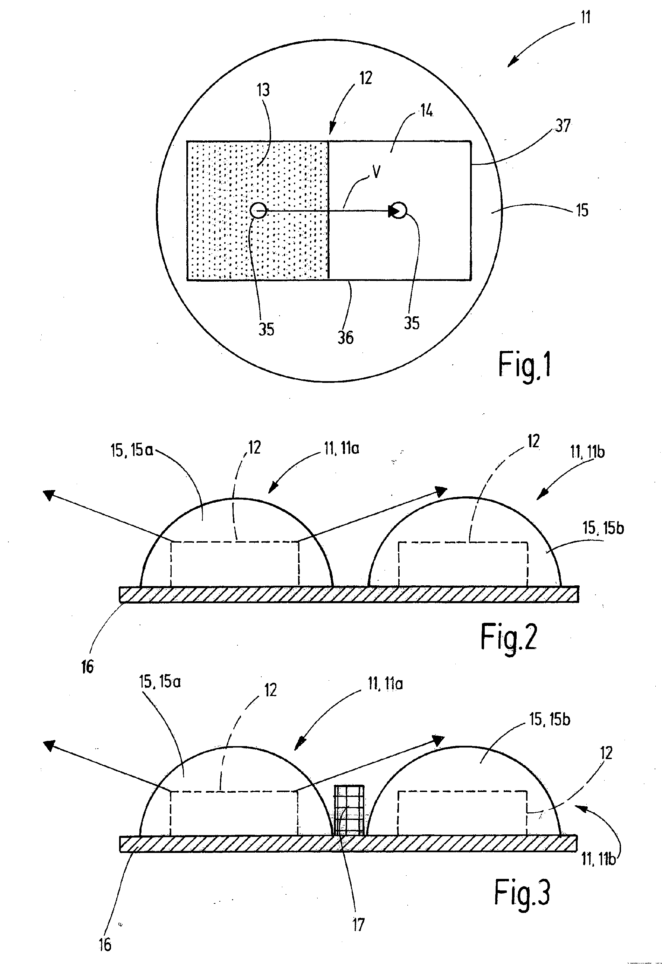

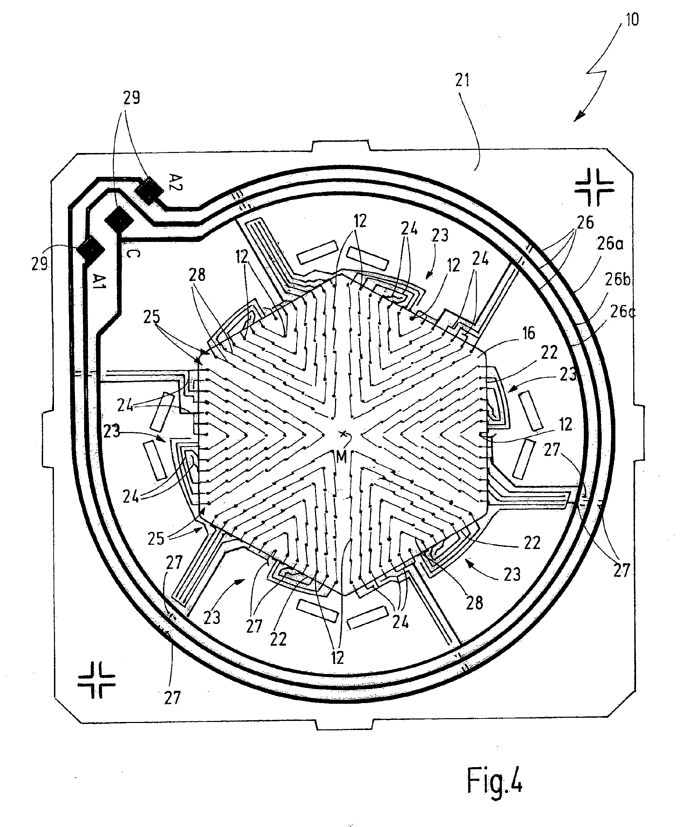

Die Figur 4 zeigt eine Leuchtdiodenanordnung 10, die eine Vielzahl von Leuchtdioden 11 aufweist. Die Leuchtdiode 11 weist einen Diodenchip 12 mit einer Anodenkontaktfläche 13 und einer Kathodenkontaktfläche 14 sowie einen Leuchtstoffkörper 15 auf (Figuren 1 bis 3). Der Leuchtstoffkörper 15 dient dazu, die Lichtfarbe oder die Farbtemperatur der Leuchtdiode 11 zu bestimmen. Hierfür weist der Leuchtstoffkörper 15 einen Leuchtstoff auf oder besteht aus einem solchen Leuchtstoff.

Bei dem hier beschriebenen Ausführungsbeispiel weist die Leuchtdiodenanordnung 10 mehrere erste Leuchtdioden 11a, sowie mehrere zweite Leuchtdioden 11b auf. Die ersten Leuchtdioden 11a und die zweiten Leuchtdioden 11b strahlen beispielsgemäß Licht mit einer unterschiedlichen Farbtemperatur ab. Hierfür haben die ersten Leuchtdioden 11a einen ersten Leuchtstoffkörper 15a und die zweiten Leuchtdioden 11b einen zweiten Leuchtstoffkörper 15b.

Die Leuchtdioden 11 sind auf einem gemeinsamen Träger, beispielsgemäß auf einem Reflektor 16 angeordnet. Die ersten Leuchtdioden 11a und die zweiten Leuchtdioden 11b sind dabei optisch voneinander entkoppelt. Die Anordnung der ersten Leuchtdioden 11a und der zweiten Leuchtdioden 11b ist derart, dass von einer ersten Leuchtdiode 11a abgestrahltes Licht den zweiten Leuchtstoffkörper 15b einer zweiten Leuchtdiode 11b nicht durchsetzt. Umgekehrt durchsetzt das von der zweiten Leuchtdiode 11b abgestrahlte Licht nicht den ersten Leuchtstoffkörper 15a einer ersten Leuchtdiode 11a. Diese optische Entkopplung ist in den Figuren 2 und 3 schematisch veranschaulicht. Dadurch wird verhindert, dass sich das von den unterschiedlichen Leuchtdioden 11a und 11b abgestrahlte Licht unbeabsichtigt mischt. Durch die optische Trennung kann die Farbtemperatur der Leuchtdiodenanordnung 10 zwischen der ersten Farbtemperatur der ersten Leuchtdioden 11a und der zweiten Farbtemperatur der zweiten Leuchtdioden 11b durch unabhängiges Ansteuern der ersten Leuchtdioden 11a und der zweiten Leuchtdioden 11b eingestellt werden. Die optische Entkopplung zwischen den ersten und zweiten Leuchtdioden 11a, 11b kann beispielsweise allein durch einen entsprechenden Abstand erreicht werden (Figur 2). Sollte dies allein aufgrund des zur Verfügung stehenden Raumes auf dem Reflektor 16 nicht möglich sein, kann zwischen einer ersten Leuchtdiode 11a und einer zweiten Leuchtdiode 11b ein optisches Trennmittel 17 angeordnet werden, das für die abgestrahlten Lichtwellenlängen nicht transparent ist. Das optische Trennmittel 17 kann beispielsweise von einem Vorsprung des Reflektors gebildet sein. Die Leuchtdioden könnten alternativ oder zusätzlich auch in separaten Vertiefungen des Trägers bzw. Reflektors 16 angeordnet sein.

In Figur 4 sind die Leuchtdioden 11 lediglich durch den jeweils zugeordneten Diodenchip 12 veranschaulicht. Wie in Figur 4 zu erkennen ist, gehört zu der Leuchtdiodenanordnung 10 auch eine Leiterplatte 21, die mit dem Reflektor 16 verbunden ist. Der Reflektor 16 ist beim bevorzugten Ausführungsbeispiel frei von Leiterbahnen. Er weist eine ebene, vorzugsweise spiegelnde Oberfläche auf, auf der die Diodenchips 12 angeordnet sind. Beim Ausführungsbeispiel besteht der Reflektor 16 aus Aluminium. Er hat die Form eines regelmäßigen n-Ecks, insbesondere mit n>4, beispielsgemäß eines Sechsecks.

Jeder Seitenkante 22 des Reflektors 16 ist ein Anschlussbereich 23 der Leiterplatte 21 zugeordnet. In jedem Anschlussbereich 23 sind mehrere Anschlussleiterbahnen 24 vorhanden, die zur elektrischen Verbindung mit einer diesem Anschlussbereich 23 zugeordneten Leuchtdiodengruppe 25 dienen. Die Leuchtdioden 11 der Leuchtdiodenanordnung 10 sind in mehrere Leuchtdiodengruppen 25 unterteilt, wobei beim Ausführungsbeispiel jede Leuchtdiodengruppe 25 dieselbe Anzahl von Leuchtdioden 11 aufweist. Beim Ausführungsbeispiel sind sechs Leuchtdiodengruppen 25 mit jeweils 49 Leuchtdioden 11 vorgesehen. Die Anzahl der Leuchtdiodengruppen 25 entspricht der Anzahl der Seitenkanten 22 des Reflektors 16.

Die Leiterplatte 21 weist außerdem Ansteuerleiterbahnen 26 auf. Es sind mindestens zwei Ansteuerleiterbahnen 26 vorhanden. Beim Ausführungsbeispiel weist die Leuchtdiodenanordnung 10 erste Leuchtdioden 11a und zweite Leuchtdioden 11b auf. Um diese beiden Leuchtdiodentypen separat ansteuern zu können, sind elektrisch unabhängige Ansteuerverbindungen erforderlich. Deshalb sind erfindungsgemäß auf der Leiterplatte 21 drei Ansteuerleiterbahnen 26 vorhanden. Die Anodenkontaktflächen 13 der jeweils ersten bzw. letzten ersten Leuchtdioden 11a einer Winkelanordnung sind mit einer ersten Ansteuerleitung 26a und die Anodenkontaktflächen 13 der jeweils ersten bzw. letzten zweiten Leuchtdioden 11b einer Winkelanordnung sind mit einer zweiten Ansteuerleitung 26b verbunden. Die Kathodenkontaktflächen 14 der entsprechenden Leuchtdioden 11 sind mit einer dritten Ansteuerleitung 26c verbunden.

In Figur 4 ist zu erkennen, dass auf der Leiterplatte 21 nicht alle für den Betrieb notwendigen elektrischen Verbindungen zwischen den Anschlussleiterbahnen 24 und den Ansteuerleiterbahnen 26 durch Leiterbahnen gebildet sind. Auf der Leiterplatte 21 sind Verbindungsstellen 27 in Form von kurzen Kupferbahnen oder Kupferflächen vorhanden. An diesen Verbindungsstellen 27 können Bonddrähte angebondet und auf diese Weise eine elektrische Verbindung zwischen zwei Verbindungsstellen 27 hergestellt werden. Abhängig von der gewünschten elektrischen Schaltung bestehen mehrere Verbindungsmöglichkeiten, so dass beim Herstellen der elektrischen Verbindungen über die Bonddrähte 28 zumindest ein Freiheitsgrad verbleibt, beispielsweise um Leuchtdioden 11 einer Leuchtdiodengruppe 25 in Serie und/oder parallel zueinander zu schalten oder um Leuchtdioden aus unterschiedlichen Leuchtdiodengruppen miteinander zu verschalten. Da die Verbindung zwischen den Diodenchips 12 auf dem Reflektor 16 ohnehin in einen Bondprozess mit Hilfe von Bonddrähten 28 hergestellt wird, kann im gleichen Prozess auch die elektrische Verbindung zwischen den Diodenchips 12 und dem zugeordneten Anschlussbereich 23 sowie dem Anschlussbereich 23 und den Ansteuerleiterbahnen 26 hergestellt werden. Durchkontaktierungen, Lötbrücken oder ähnliches auf der Leiterplatte 21 können vermieden werden. Vorzugsweise sind lediglich auf einer Seite der Leiterplatte 21 Leiterbahnen 24, 26 vorhanden.

Die Ansteuerleiterbahnen 26 verlaufen beim Ausführungsbeispiel um den Reflektor 16 und/oder um die Anschlussbereiche 23 herum und bilden beispielsgemäß jeweils einen elektrisch vollständig geschlossenen Ring. Jede Ansteuerleiterbahn 26 weist eine Anschlussfläche 29 zum elektrischen Verbinden einer elektrischen Leitung auf. Die Anschlussflächen 29 sind vorzugsweise benachbart zueinander angeordnet. Beim Ausführungsbeispiel gemäß Figur 4 sind die Anschlussflächen 29 in einem Eckbereich der Leiterplatte 21 vorgesehen.

Beim Ausführungsbeispiel sind die Leuchtdiodengruppen 25 regelmäßig verteilt um eine Hochachse durch den Mittelpunkt M des Reflektors 16 angeordnet. Die Position und die Orientierung der Leuchtdioden 11 einer beliebigen Leuchtdiodengruppe 25 ergibt sich durch die Drehung einer beliebigen anderen Leuchtdiodengruppe 25 um die Hochachse durch den Mittelpunkt M. Dadurch wird das Bestücken und Bonden der Diodenchips 12 vereinfacht und eine symmetrische Lichtabstrahlung der Leuchtdiodenanordnung 10 beim Betrieb in einer Leuchte erreicht.

Die Anodenkontaktfläche 13 und die Kathodenkontaktfläche 14 eines Diodenchips 12 weisen jeweils eine Bondstelle 35 auf. Die Bondstellen 35 befinden sich beim Ausführungsbeispiel auf einer gemeinsamen Seite des Diodenchips 12, die dem Reflektor 16 abgewandt ist. Die Diodenchips 12 haben beispielsgemäß eine rechteckige Kontur mit einer Längsseite 36 und einer Querseite 37. Die Orientierung eines Diodenchips ist durch einen Richtungsvektor V bestimmt, der von der Anodenkontaktfläche 13 zur Kathodenkontaktfläche 14 in der Ebene des Reflektors 16 ausgerichtet ist und beim Ausführungsbeispiel parallel zu der Längsseite 36 ausgerichtet ist. Die Diodenchips 12 sind in einer genau definierten und durch den Richtungsvektor V bestimmten Orientierung auf dem Reflektor 16 angeordnet, um das Bestücken des Reflektors 16 mit den Diodenchips 12 und das Herstellen der Bondverbindung mit Hilfe von Bonddrähten 28 zwischen Diodenchips 12 einer Leuchtdiodengruppe 25 zu vereinfachen.

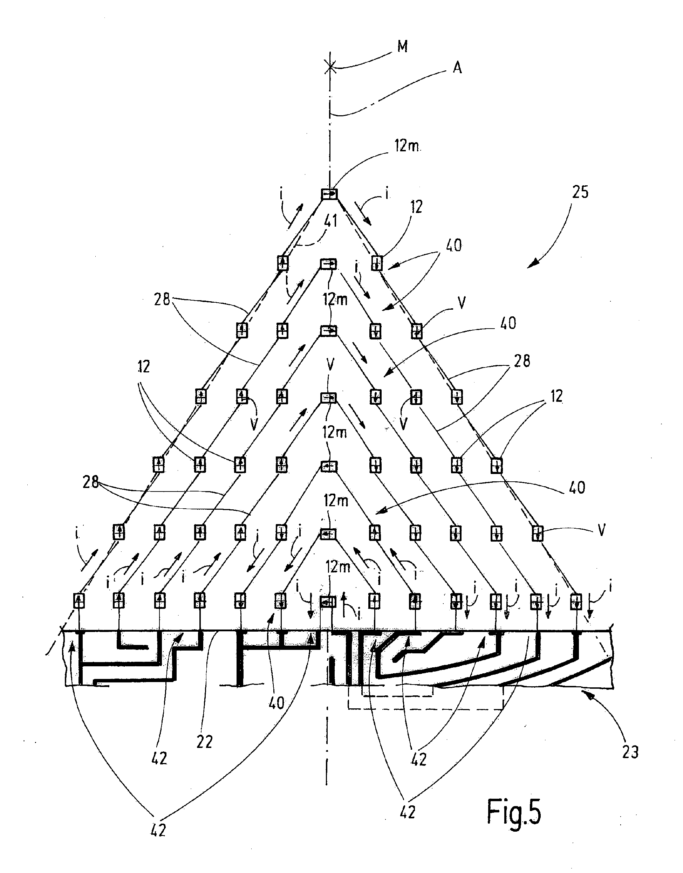

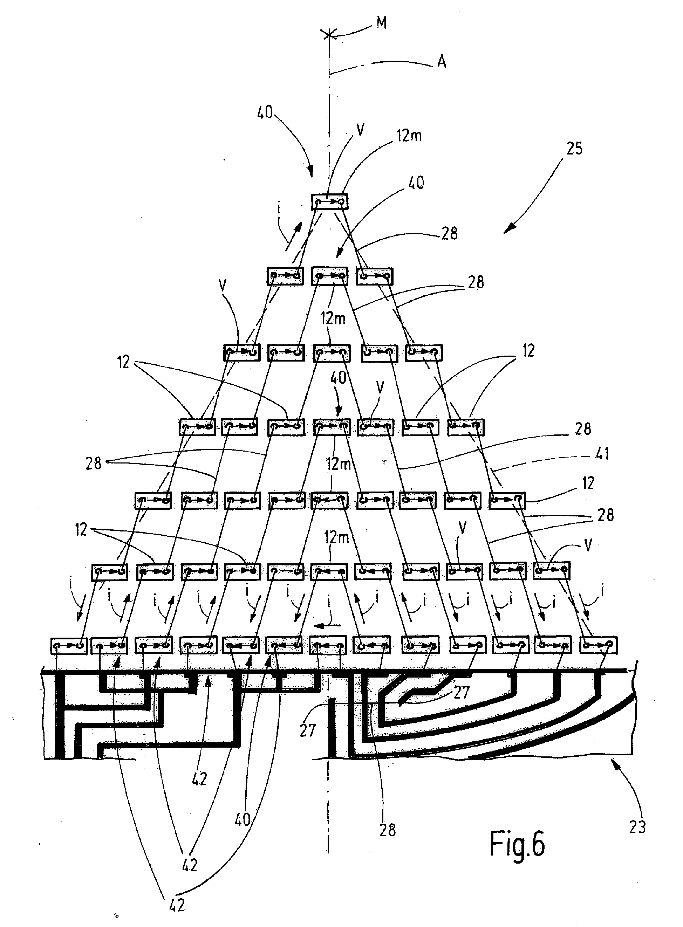

In den Figuren 5 und 6 ist jeweils eine Leuchtdiodengruppe 25 der Leuchtdiodenanordnung 10 gemäß Figur 4 veranschaulicht. Die in den Figuren 5 und 6 gezeigten Orientierungen der Diodenchips 12 stellen zwei bevorzugte Ausführungsformen dar. Alle Leuchtdiodengruppen 25 der Leuchtdiodenanordnung 10 haben bevorzugt entweder die in Figur 5 oder die in Figur 6 dargestellte Anordnung und Orientierung der Diodenchips 12.

Bei beiden Ausführungsformen sind die Diodenchips 12 der Leuchtdiodengruppe in einer dreieckähnlichen Form angeordnet. Die Spitze dieses Dreiecks weist zum Mittelpunkt M des Reflektors 16 hin. Jeweils ein Teil der Diodenchips 12 der Leuchtdiodengruppe 25 bildet eine Winkelanordnung 40. Jede Leuchtdiodengruppe 25 weist mehrere solcher Winkelanordnungen 40 auf, wobei beim Ausführungsbeispiel jeweils sechs solcher Winkelanordnungen 40 vorhanden sind. Jede Winkelanordnung 40 enthält eine ungerade Zahl von Diodenchips 12. Diese sind entlang einer abgewinkelten Linie 41 angeordnet, wie sie gestrichelt beispielhaft jeweils für die äußerste Winkelanordnung 40 in Figuren 5 und 6 veranschaulicht ist. Die Spitze dieser abgewinkelten Linie 41 liegt auf einer Achse A rechtwinkelig zur Hochachse durch den Mittelpunkt M des Reflektors 16. An oder am nächsten zu der Spitze dieser abgewinkelten Linie 41 ist ein mittlerer Diodenchip 12m angeordnet. Dieser mittlere Diodenchip 12m ist auf der Achse A positioniert. Der Richtungsvektor V des mittleren Diodenchips 12m verläuft rechtwinklig zur Achse A. Abgesehen von den Richtungsvektoren V der mittleren Diodenchips 12m verlaufen alle anderen Richtungsvektoren der übrigen Diodenchips 12 der Leuchtdiodengruppe 25 parallel zur Achse A. Die Leuchtdiodengruppe 25 weist somit Diodenchips 12 mit vier Orientierungen auf: Richtungsvektoren V, die von der zugeordneten Seitenkante 22 des Reflektors 16 weg oder zu dieser zweiten Kante hin weisen und jeweils parallel zur Achse A verlaufen und Richtungsvektoren V die in entgegengesetzte Richtungen rechtwinklig zu dieser Achse A ausgerichtet sind.

Bei dem ersten Ausführungsbeispiel gemäß Figur 5 sind mehrere Reihenschaltungen 42 von Leuchtdioden 11 bzw. Diodenchips 12 vorhanden. Beim Ausführungsbeispiel sind vier Reihenschaltungen 42 vorgesehen. Zu jeder Reihenschaltung 42 gehören die Leuchtdioden 11 bzw. Diodenchips 12 von einer oder zwei Winkelanordnungen 40. Die äußerste Winkelanordnung 40 mit den meisten Diodenchips 12 ist über eine Anschlussleiterbahn 24 im zugeordneten Anschlussbereich 23 mit einem einzelnen innersten Diodenchip in Reihe geschaltet, der auf der Achse A angeordnet ist und dessen Richtungsvektor V daher rechtwinklig zu dieser Achse A verläuft.

Die Winkelanordnung 40 mit der zweitgrößten Anzahl von Diodenchips 12 ist in Reihe geschaltet mit der kleinsten Winkelanordnung 40 mit lediglich drei Diodenchips 12, die benachbart zum innersten Diodenchip angeordnet ist. Die Winkelanordnung 40 mit der drittgrößten Anzahl von Diodenchips 12 ist in Reihe geschaltet mit der zweitkleinsten Winkelanordnung 40 mit fünf Diodenchips. Bei dieser Art der Reihenschaltung von jeweils zwei Winkelanordnungen 40 bzw. einer Winkelanordnung 40 mit dem innersten Diodenchip lassen sich Reihenschaltungen mit jeweils gleicher Anzahl von Diodenchips 12 bzw. Leuchtdioden 11 herstellen. Beim Ausführungsbeispiel ist lediglich eine Reihenschaltung 42 vorhanden, die eine kleinere Anzahl von Diodenchips 12 bzw. Leuchtdioden 11 aufweist verglichen mit den übrigen Reihenschaltungen 42. Diese Reihenschaltung bzw. Winkelanordnung kann mit einer entsprechenden Reihenschaltung bzw. Winkelanordnung einer anderen Leuchtdiodengruppe über die Leiterbahnen auf der Leiterplatte 21 verschaltet werden. Über diese Verschaltung sind dann wiederum genauso viele Diodenchips 12 bzw. Leuchtdioden 11 miteinander in Reihe verbunden wie in den anderen Reihenschaltungen. Die Winkelanordnungen 40 sind so nebeneinander angeordnet, dass sich die Anzahl der Diodenchips 12 ausgehend von der kleinsten Winkelanordnung mit drei Diodenchips 12 zur benachbarten Winkelanordnung jeweils um zwei erhöht.

Die Stromflussrichtung durch die Diodenchips 12 ist durch die Pfeile i gekennzeichnet.

Jede Reihenschaltung 42 besteht entweder nur aus ersten Leuchtdioden 11a oder nur aus zweiten Leuchtdioden 11b. Auf diese Weise können die Reihenschaltungen 42 mit ersten Leuchtdioden 11a unabhängig von den Reihenschaltungen 42 mit zweiten Leuchtdioden 11b angesteuert und das von der Leuchtdiodengruppe 25 und mithin von der Leuchtdiodenanordnung 10 abgestrahlte Licht, insbesondere die Farbtemperatur und/oder die Lichtfarbe und/oder die Helligkeit, anhand der jeweiligen Größe des Stromes durch eine Reihenschaltung 42 eingestellt werden.

Das zweite Ausführungsbeispiel der Anordnung bzw. Ausrichtung der Diodenchips 12 einer Leuchtdiodengruppe 25 unterscheidet sich von dem ersten Ausführungsbeispiel nach Figur 5 dadurch, dass alle Richtungsvektoren V aller Diodenchips 12 rechtwinklig zur Achse A orientiert sind. Die Richtungsvektoren V der Diodenchips nach Figur 6 sind daher entweder parallel oder antiparallel zueinander ausgerichtet. Bei diesem Ausführungsbeispiel weisen die Diodenchips 12 einer gemeinsamen Leuchtdiodengruppe 25 nur zwei verschiedene Orientierungen auf. Im übrigen entspricht die elektrische Verbindung der Diodenchips sowie die Unterteilung der Diodenchips 12 in Winkelanordnungen 40 und Reihenschaltungen 42 der Ausführungsform nach Figur 5. Es wird daher auf die vorstehende Beschreibung verwiesen.

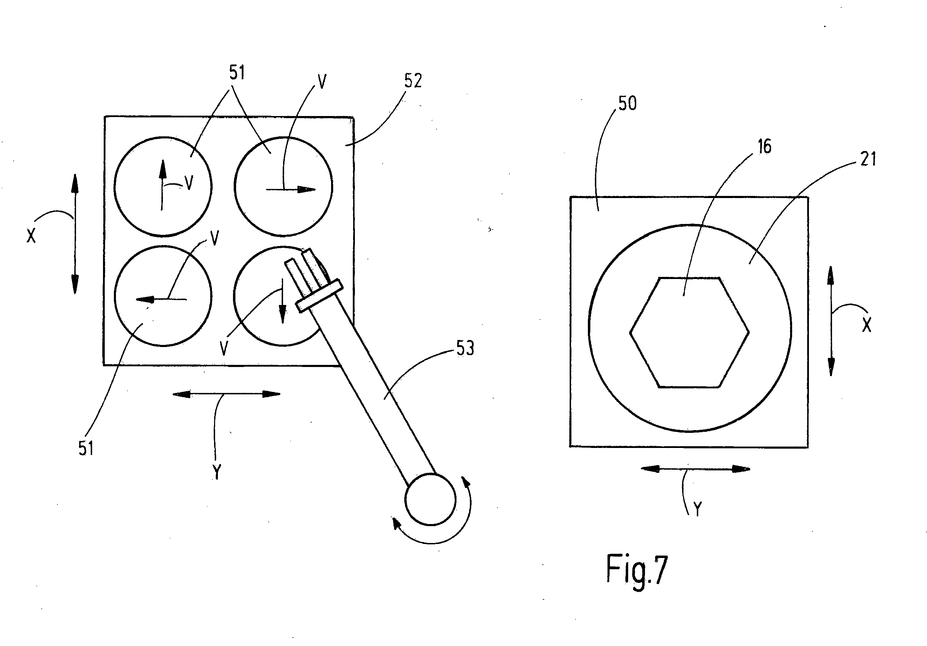

In Figur 7 ist das Bestücken des Reflektors 16 mit den Diodenchips 12 äußerst schematisiert veranschaulicht. Der Reflektor 16 ist gemeinsam mit der Leiterplatte 21 in einer Halterung 50 angeordnet. Die Halterung 50 ist horizontal sowohl in x-Richtung, als auch in y-Richtung bewegbar. Weitere Bewegungsachsen weist die Halterung 50 beispielsgemäß nicht auf. Einer oder beispielsgemäß mehrere Wafer 51 sind auf einem ebenfalls horizontal bewegbaren Tisch 52 angeordnet. Der Tisch 52 ist analog zur Halterung 50 insbesondere lediglich in x-Richtung sowie in y-Richtung bewegbar. Eine Greifeinrichtung 53 ist um eine Vertikalachse schwenkbar und dient dazu, die auf den Wafern 51 vorhandenen Diodenchips 12 zu greifen und auf dem Reflektor 16 abzulegen. Um die gewünschte Orientierung der Diodenchips beim Ablegen auf dem Reflektor 16 zu erreichen, sind auf dem Tisch 52 mehrere und beispielsgemäß vier Wafer 51 angeordnet, wobei die Diodenchips 12 jedes Wafers 51 in eine andere Richtung weisen. Die Richtungsvektoren V der Diodenchips 12 auf den Wafern 51 sind in Figur 7 veranschaulicht.

Bei einer abgewandelten Ausführungsform kann die Halterung 50 in wenigen vorgegebenen Schritten um eine Vertikalachse drehbar sein, beispielsweise in 120 Grad-Schritten, so dass dadurch drei unterschiedliche Ausrichtungen des Reflektors 16 um die Vertikalachse einstellbar sind.

Nachdem die Diodenchips 12 in der zuvor beschriebenen Orientierung auf dem Reflektor 16 angeordnet wurden, werden die Diodenchips wie in den Figuren 5 und 6 dargestellt über Bonddrähte 28 elektrisch miteinander verbunden, so dass die Reihenschaltungen 42 gebildet werden. Außerdem werden jeweils der erste und der letzte Diodenchip 12 einer Reihenschaltung 42 über jeweils einen Bonddraht mit einer Anschlussleiterbahn 24 des zugeordneten Anschlussbereichs 23 auf der Leiterplatte 21 verbunden. Innerhalb dieses Bondprozesses werden auch die Anschlussleiterbahnen 24 mit einer der Ansteuerleiterbahnen 26 über Bonddrähte 28 verbunden, sofern keine fest vorgegebene Verbindung auf der Leiterplatte 21 besteht. Dadurch können zum einen Freiheitsgrade für eine flexible Schaltung ausgenutzt werden. Zum anderen können Lötprozesse und Durchkontaktierungen auf der Leiterplatte 21 vermieden werden.

Schließlich werden die Leuchtstoffkörper 15 auf die Diodenchips 12 aufgebracht. Dabei wird vorzugsweise jedem Diodenchip 12 ein separater Leuchtstoffkörper 15 zugeordnet, der beispielsweise eine kalottenförmige Form aufweisen kann. Es ist auch möglich, mehreren Diodenchips 12 einen gemeinsamen Leuchtstoffkörper 15 zuzuordnen und sozusagen einen linienförmigen Leuchtstoffkörper für mehrere Diodenchips 12 herzustellen.

Die Erfindung betrifft eine Leuchtdiodenanordnung 10 mit mehreren Leuchtdioden 11. Die Leuchtdioden 11 sind in mehrere Leuchtdiodengruppen 25 mit jeweils gleicher Anzahl von Leuchtdioden 11 unterteilt. Die Leuchtdioden 11 einer Leuchtdiodengruppe 25 sind auf einem Reflektor 16, der allen Leuchtdiodengruppen 25 zugeordnet ist, in einer Form eines gleichseitigen Dreiecks angeordnet, wobei die Grundseite einer Seitenkante 22 des Reflektors 16 zugeordnet und die Spitze dieses gleichseitigen Dreiecks den Mittelpunkt M des Reflektors 16 zugeordnet ist. Zur Erzielung der dreieckförmigen Form sind jeweils eine ungerade Anzahl der Leuchtdioden 11 entlang einer abgewinkelten Linie 41 angeordnet, die parallel zu den beiden Seiten des Dreiecks verläuft. Die jeweils mittlere Leuchtdiode, bzw. deren Leuchtdiodenchip 12m ist auf einer Achse A durch den Mittelpunkt M des Reflektors angeordnet. Die Diodenchips 12 haben eine rechteckförmige Kontur. Die Längsseiten 26 der mittleren Diodenchips 12m verlaufen rechtwinklig zur Achse A. Die Längsseiten 36 aller übrigen Diodenchips verlaufen parallel zueinander entweder parallel zur Achse A oder rechtwinklig zur Achse A.

### Bezugszeichenliste:

- 10: Leuchtdiodenanordnung
- 11: Leuchtdiode
- 11a: erste Leuchtdiode
- 11b: zweite Leuchtdiode
- 12: Diodenchip
- 13: Anodenkontaktfläche
- 14: Kathodenkontaktfläche
- 15: Leuchtstoffkörper
- 15a: erster Leuchtstoffkörper
- 15b: zweiter Leuchtstoffkörper
- 16: Reflektor
- 17: optisches Trennmittel

- 21: Leiterplatte
- 22: Seitenkante des Reflektors
- 23: Anschlussbereich
- 24: Anschlussleiterbahn
- 25: Leuchtdiodengruppe
- 26: Ansteuerleiterbahn
- 26a: erste Ansteuerleiterbahn
- 26b: zweite Ansteuerleiterbahn
- 26c: dritte Ansteuerleiterbahn
- 27: Verbindungsstelle
- 28: Bonddraht
- 29: Anschlussfläche

- 35: Bondstelle
- 36: Längsseite
- 37: Querseite

- 40: Winkelanordnung
- 41: abgewinkelte Linie
- 42: Reihenschaltung

- 50: Halterung
- 51: Wafer
- 52: Tisch
- 53: Greifeinrichtung

- A: Achse
- M: Mittelpunkt
- V: Richtungsvektor
- x: Horizontalrichtung
- y: Horizontalrichtung

## Patentansprüche

1. Leuchtdiodenanordnung (10),
mit einem Träger oder Reflektor (16),
mit mehreren Leuchtdiodengruppen (25) mit jeweils mehreren Leuchtdioden (11), die auf dem Träger oder Reflektor (16) angeordnet sind, wobei jede Leuchtdiode (11) einen Diodenchip (12) mit einer Anodenkontaktfläche (13) und einer Kathodenkontaktfläche (14) aufweist,
wobei die Orientierung des Diodenchips (12) um seine rechtwinklig zum Träger oder Reflektor (16) ausgerichtete Hochachse durch einen Richtungsvektor (V) definiert ist, der rechtwinklig zu der Hochachse des Diodenchips (12) verläuft und eine Projektion eines von der Anodenkontaktfläche (13) zu der Kathodenkontaktfläche (14) verlaufenden Vektors ist,
wobei ein Teil der Diodenchips (12) einer Leuchtdiodengruppe (25) eine Winkelanordnung (40) bildet, bei der die Diodenchips (12) entlang einer abgewinkelten Linie (41) angeordnet sind, und der Richtungsvektor (V) des an oder am nächsten zu einer Spitze der wenigstens einen abgewinkelten Linie (41) angeordneten mittleren Diodenchips (12m) rechtwinklig zu einer Winkelhalbierenden (A) durch die Spitze der abgewinkelten Linie (41) ausgerichtet ist,
wobei entweder die Richtungsvektoren (V) aller Diodenchips (12) derselben Winkelanordnung (40) oder derselben Leuchtdiodengruppe (25) rechtwinklig zur Winkelhalbierenden (A) orientiert sind oder wobei abgesehen von dem mittleren Diodenchip (12m) die Richtungsvektoren (V) aller anderen Diodenchips (12) derselben Winkelanordnung (40) parallel zu der Winkelhalbierenden (A) orientiert sind,
und wobei die Diodenchips (12) einer gemeinsamen Winkelanordnung (40) elektrisch in Reihe geschaltet sind,
**dadurch gekennzeichnet,**
**dass** die abgewinkelte Linie (41) einmalig abgewinkelt ist, so dass die Diodenchips (12) entlang zweier sich schneidender Geraden angeordnet sind,
und **dass** jede Leuchtdiodengruppe (25) mehrere Winkelanordnungen (40) mit jeweils unterschiedlich vielen Diodenchips (12) aufweist und dass mindestens zwei Winkelanordnungen (40) mit jeweils unterschiedlich vielen Diodenchips (12) derart zu einer Reihenschaltung (42) elektrisch verbunden sind, dass die Leuchtdiodengruppe (25) mindestens zwei Reihenschaltungen (42) aufweist, die jeweils die gleiche Anzahl von Diodenchips (12) aufweisen.

2. Leuchtdiodenanordnung nach Anspruch 1,
**dadurch gekennzeichnet, dass** mehrere Leuchtdiodengruppen (25) vorhanden sind, wobei sich die Position und Orientierung der Diodenchips (12) einer beliebigen Leuchtdiodengruppe (25) auf dem Träger oder Reflektor (16) durch eine Drehung einer anderen Leuchtdiodengruppe (25) um eine rechtwinkelig zum Träger oder Reflektor (16) durch dessen Mittelpunkt (M) verlaufende Hochachse ergibt.

3. Leuchtdiodenanordnung nach Anspruch 1 oder 2,
**dadurch gekennzeichnet, dass** jede Leuchtdiode (11) einen dem Diodenchip (12) zugeordneten Leuchtstoffkörper (15) aufweist.

4. Leuchtdiodenanordnung nach Anspruch 3,
**dadurch gekennzeichnet, dass** mehreren oder allen Diodenchips (12) derselben Winkelanordnung (40) ein gemeinsamer Leuchtstoffkörper (15) zugeordnet ist.

5. Leuchtdiodenanordnung nach Anspruch 3 oder 4,
**dadurch gekennzeichnet, dass** jede Leuchtdiodengruppe (25) wenigstens eine erste Leuchtdiode (11a) mit einem ersten Leuchtstoffkörper (15a) und wenigstens eine zweite Leuchtdiode (11b) mit einem zweiten Leuchtstoffkörper (15b) aufweist, wobei der erste Leuchtstoffkörper (15a) und der zweite Leuchtstoffkörper (15b) bei einer Anregung durch den zugeordneten Diodenchip (12) Licht mit unterschiedlichen Lichtfarben und/oder oder unterschiedlichen Farbtemperaturen emittieren.

6. Leuchtdiodenanordnung nach Anspruch 5,
**dadurch gekennzeichnet, dass** die wenigstens eine erste Leuchtdiode (11a) und die wenigstens eine zweite Leuchtdiode (11b) zu unterschiedlichen Winkelanordnungen (40) oder zu unterschiedlichen Reihenschaltungen (42) einer gemeinsamen Leuchtdiodengruppe (25) gehören.

7. Leuchtdiodenanordnung nach Anspruch 5 oder 6,
**dadurch gekennzeichnet, dass** der erste Leuchtstoffkörper (15a) der wenigstens einen ersten Leuchtdiode (11a) und der zweite Leuchtstoffkörper (15b) der wenigstens einen zweiten Leuchtdiode (11b) optisch voneinander getrennt sind.

8. Leuchtdiodenanordnung nach einem der vorhergehenden Ansprüche,
**dadurch gekennzeichnet, dass** der Träger oder Reflektor (16) die Kontur eines regelmäßigen Polygons aufweist.

9. Leuchtdiodenanordnung (10) nach einem der vorhergehenden Ansprüche,
mit einer Leiterplatte (21), die mit dem Träger oder Reflektor (16) verbunden ist, und die für jede Leuchtdiodengruppe (25) einen Anschlussbereich (23) mit mehreren Anschlussleiterbahnen (24) aufweist, wobei jede Leuchtdiodengruppe (25) über Bonddrähte (28) mit den Anschlussleiterbahnen (24) im Anschlussbereich (23) verbunden ist,
mit wenigstens zwei Ansteuerleiterbahnen (26) auf der Leiterplatte (21), die um die Anschlussbereiche (23) und/oder den Träger oder Reflektor (16) herum verlaufen,
wobei zumindest eine Anschlussleiterbahn (24) jedes Anschlussbereichs (23) über einen Bonddraht (28) mit einer der Ansteuerleiterbahnen (26) elektrisch verbunden ist.

10. Leuchtdiodenanordnung nach Anspruch 9,
**dadurch gekennzeichnet, dass** die Anschlussbereiche (23) unmittelbar benachbart zum Träger oder Reflektor (16) angeordnet sind.

11. Leuchtdiodenanordnung nach Anspruch 9 oder 10,
**dadurch gekennzeichnet, dass** der Träger oder Reflektor (16) die Kontur eines Polygons hat, wobei jeder Seitenkante (22) des Trägers oder Reflektors (16) ein Anschlussbereich (23) zugeordnet ist.

12. Verfahren zur Herstellung einer Leuchtdiodenanordnung (10), mit folgenden Schritten:
- Bereitstellen einer Leiterplatte (21) mit einem Träger oder Reflektor (16),
- Bereitstellen von Diodenchips (12) mit jeweils einer Anodenkontaktfläche (13) und einer Kathodenkontaktfläche (14), wobei die Orientierung des Diodenchips (12) um seine rechtwinklig zum Träger oder Reflektor (16) ausgerichtete Hochachse durch einen Richtungsvektor (V) definiert ist, der rechtwinklig zu der Hochachse des Diodenchips (12) verläuft und eine Projektion eines von der Anodenkontaktfläche (13) zu der Kathodenkontaktfläche (14) verlaufenden Vektors ist,
- Anordnen der Diodenchips (12) auf dem Träger oder Reflektor (16) in mehreren Leuchtdiodengruppen (25) mit jeweils mehreren Diodenchips (12), wobei jede Leuchtdiodengruppe (25) mehrere Winkelanordnungen (40) mit jeweils unterschiedlich vielen Diodenchips (12) aufweist, die entlang zweier sich schneidender Geraden wenigstens einer einmalig abgewinkelten Linie (41) angeordnet werden, derart, dass der Richtungsvektor (V) des an oder am nächsten zu einer Spitze der abgewinkelten Linie (41) angeordneten mittleren Diodenchips (12m) rechtwinklig zu einer Winkelhalbierenden (A) durch die Spitze der abgewinkelten Linie (41) ausgerichtet ist, dass entweder die Richtungsvektoren (V) aller Diodenchips (12) derselben Winkelanordnung (40) oder derselben Leuchtdiodengruppe (25) parallel und/oder antiparallel zueinander orientiert sind oder dass der Richtungsvektor (V) des an oder am nächsten zu der Spitze der wenigstens einen abgewinkelten Linie (41) angeordneten mittleren Diodenchips (12m) eine andere Orientierung aufweist als die Richtungsvektoren (V) der anderen Diodenchips (12) derselben Winkelanordnung (40),
- elektrisches Verbinden der Diodenchips (12) von mindestens zwei winkelanordnungen (40) mit jeweils unterschiedlich vielen Diodenchips (12) derart zu einer Reihenschaltung (42), dass die Leuchtdiodengruppe (25) mindestens zwei Reihenschaltungen (42) aufweist, die jeweils die gleiche Anzahl von Diodenchips (12) aufweisen.

## Claims

1. Light-emitting diode array (10),
with a holder or reflector (16),
with multiple light-emitting diode groups (25) respectively with multiple light-emitting diodes (11), which are arranged on the holder or reflector (16), wherein each light-emitting diode (11) has a diode chip (12) with an anode contact face (13) and a cathode contact face (14),
wherein the orientation of the diode chip (12) around its vertical axis oriented at right angles to the holder or reflector (16) is defined by a direction vector (V), which runs at right angles to the vertical axis of the diode chip (12) and is a projection of a vector running from the anode contact face (13) to the cathode contact face (14),
wherein a part of the diode chips (12) of a light-emitting diode group (25) forms an angle arrangement (40), in which the diode chips (12) are arranged along an angled line (41), and the direction vector (V) of the middle diode chip (12m) arranged on or closest to a tip of the at least one angled line (41) is oriented at right angles to a bisector (A) through the tip of the angled line (41),
wherein either the direction vectors (V) of all the diode chips (12) of the same angle arrangement (40) or of the same light-emitting diode group (25) are oriented at right angles to the bisector (A) or wherein the direction vectors (V) of all the other diode chips (12) of the same angle arrangement (40) except the middle diode chip (12m) are oriented parallel to the bisector (A),
and wherein the diode chips (12) of a common angle arrangement (40) are electrically connected in series,
**characterised in that**
the angled line (41) is angled once, so that the diode chips (12) are arranged along two intersecting straight lines,
and that each light-emitting diode group (25) has multiple angle arrangements (40) respectively with a different number of diode chips (12) and that at least two angle arrangements (40) respectively with a different number of diode chips (12) are electrically connected to a series connection (42) in such a manner that the light-emitting diode group (25) has at least two series connections (42), which respectively have the same number of diode chips (12).

2. Light-emitting diode array according to claim 1, **characterised in that** multiple light-emitting diode groups (25) are provided, wherein the position and orientation of the diode chips (12) of any one light-emitting diode group (25) on the holder or reflector (16) are achieved by a rotation of another light-emitting diode group (25) around a vertical axis running at right angles to the holder or reflector (16) through the centrepoint (M) thereof.

3. Light-emitting diode array according to claim 1 or 2, **characterised in that** each light-emitting diode (11) has a phosphor body (15) associated with the diode chip (12).

4. Light-emitting diode array according to claim 3, **characterised in that** multiple or all diode chips (12) of the same angle arrangement (40) have an associated common phosphor body (15).

5. Light-emitting diode array according to claim 3 or 4, **characterised in that** each light-emitting diode group (25) has at least one first light-emitting diode (11a) with a first phosphor body (15a) and at least one second light-emitting diode (11b) with a second phosphor body (15b), wherein on stimulation by the associated diode chip (12) the first phosphor body (15a) and the second phosphor body (15b) emit light with different light colours and/or different colour temperatures.

6. Light-emitting diode array according to claim 5, **characterised in that** the at least one first light-emitting diode (11a) and the at least one second light-emitting diode (11b) belong to different angle arrangements (40) or to different series connections (42) of a common light-emitting diode group (25).

7. Light-emitting diode array according to claim 5 or 6, **characterised in that** the first phosphor body (15a) of the at least one first light-emitting diode (11a) and the second phosphor body (15b) of the at least one second light-emitting diode (11b) are optically separate from one another.

8. Light-emitting diode array according to one of the preceding claims, **characterised in that** the holder or reflector (16) has the contour of a regular polygon.

9. Light-emitting diode array (10) according to one of the preceding claims,
with a printed circuit board (21), which is connected to the holder or reflector (16) and which for each light-emitting diode group (25) has a connection region (23) with multiple connecting conductive tracks (24), wherein each light-emitting diode group (25) is connected to the connecting conductive tracks (24) in the connection region (23) by means of bonding wires (28),
with at least two driving conductive tracks (26) on the printed circuit board (21), which run around the connection regions (23) and/or the holder or reflector (16), wherein at least one connecting conductive track (24) of each connection region (23) is electrically connected to one of the driving conductive tracks (26) by means of a bonding wire (28).

10. Light-emitting diode array according to claim 9, **characterised in that** the connection regions (23) are arranged directly adjacent to the holder or reflector (16).

11. Light-emitting diode array according to claim 9 or 10, **characterised in that** the holder or reflector (16) has the contour of a polygon, wherein each side edge (22) of the holder or reflector (16) has an associated connection region (23).

12. Method for the production of a light-emitting diode array (10) with the following steps:
• providing a printed circuit board (21) with a holder or reflector (16),
• providing diode chips (12) respectively with an anode contact face (13) and a cathode contact face (14), wherein the orientation of the diode chip (12) around its vertical axis oriented at right angles to the holder or reflector (16) is defined by a direction vector (V), which runs at right angles to the vertical axis of the diode chip (12) and is a projection of a vector running from the anode contact face (13) to the cathode contact face (14),
• arranging the diode chips (12) on the holder or reflector (16) in multiple light-emitting diode groups (25) respectively with multiple diode chips (12), wherein each light-emitting diode group (25) has multiple angle arrangements (40) respectively with a different number of diode chips (12), which are arranged along two intersecting straight lines of at least one line (41) that is angled once in such a manner that the direction vector (V) of the middle diode chip (12m) arranged on or closest to a tip of the angled line (41) is oriented at right angles to a bisector (A) through the tip of the angled line (41), that either the direction vectors (V) of all the diode chips (12) of the same angle arrangement (40) or of the same light-emitting diode group (25) are oriented parallel and/or antiparallel to one another, or that the direction vector (V) of the middle diode chip (12m) arranged on or closest to a tip of the at least one angled line (41) has a different orientation to the direction vectors (V) of the other diode chips (12) of the same angle arrangement (40),
• electrically connecting the diode chips (12) of at least two angle arrangements (40) respectively with a different number of diode chips (12) to a series connection (25) in such a manner that the light-emitting diode group (25) has at least two series connections (42), which respectively have the same number of diode chips (12).

## Revendications

1. Agencement de diodes lumineuses ou électroluminescentes (10),
comprenant un support ou réflecteur (16),
comprenant plusieurs groupes de diodes électroluminescentes (25), comportant chacun plusieurs diodes électroluminescentes (11), qui sont disposés sur le support ou réflecteur (16), chaque diode luminescente (11) présentant une puce de diode (12) ayant une surface de contact d'anode (13) et une surface de contact de cathode (14),
sachant que l'orientation de la puce de diode (12) autour de son axe vertical, disposé à angle droit par rapport au support ou réflecteur (16), est définie par un vecteur de direction (V) qui s'étend à angle droit par rapport à l'axe vertical de la puce de diode (12) et est une projection d'un vecteur s'étendant de la surface de contact d'anode (13) jusqu'à la surface de contact de cathode (14),
sachant qu'une partie des puces de diode (12) d'un groupe de diodes électroluminescentes (25) forme un arrangement angulaire (40) dans lequel les puces de diode (12) sont disposées le long d'une ligne coudée (41), et le vecteur de direction (V) de la puce de diode médiane (12m), disposée sur une pointe ou le plus proche d'une pointe de la ligne coudée (41), au nombre d'au moins une, est orienté à angle droit par rapport à une bissectrice (A) passant par la pointe de la ligne coudée (41),
sachant que soit les vecteurs de direction (V) de toutes les puces de diode (12) du même arrangement angulaire (40) ou du même groupe de diodes électroluminescentes (25) sont orientés à angle droit par rapport à la bissectrice (A), soit les vecteurs de direction (V) de toutes les autres puces de diode (12) du même arrangement angulaire (40), à l'exception de la puce de diode médiane (12m), sont orientés parallèlement à la bissectrice (A),
et sachant que les puces de diode (12) d'un même arrangement angulaire (40) sont montées en série du point de vue électrique,
**caractérisé en ce que**
la ligne coudée (41) est coudée une seule fois, de sorte que les puces de diode (12) sont disposées le long de deux droites qui se croisent,
et **en ce que** chaque groupe de diodes électroluminescentes (25) présente plusieurs arrangements angulaires (40) comportant chacun un nombre différent de puces de diode (12), et **en ce qu'**au moins deux arrangements angulaires (40), comportant chacun un nombre différent de puces de diode (12), sont reliés électriquement pour constituer un montage série (42), de telle sorte que le groupe de diodes électroluminescentes (25) présente au moins deux montages série (42) qui comportent respectivement le même nombre de puces de diode (12).

2. Agencement de diodes électroluminescentes selon la revendication 1,
**caractérisé en ce que** plusieurs groupes de diodes électroluminescentes (25) sont prévus, sachant que la position et l'orientation des puces de diode (12) d'un groupe de diodes électroluminescentes (25) quelconque sur le support ou réflecteur (16) sont le résultat d'une rotation d'un autre groupe de diodes électroluminescentes (25) autour d'un axe vertical s'étendant à angle droit par rapport au support ou réflecteur (16) et passant par le centre (M) de celui-ci.

3. Agencement de diodes électroluminescentes selon la revendication 1 ou 2,
**caractérisé en ce que** chaque diode électroluminescente (11) présente un corps fluorescent (15) associé à la puce de diode (12).

4. Agencement de diodes électroluminescentes selon la revendication 3,
**caractérisé en ce qu'**un corps fluorescent (15) commun est associé à plusieurs ou à toutes les puces de diode (12) du même arrangement angulaire (40).

5. Agencement de diodes électroluminescentes selon la revendication 3 ou 4,
**caractérisé en ce que** chaque groupe de diodes électroluminescentes (25) présente au moins une première diode électroluminescente (11a), dotée d'un premier corps fluorescent (15a), et au moins une deuxième diode électroluminescente (11b), dotée d'un deuxième corps fluorescent (15b), sachant qu'en cas d'excitation par la puce de diode (12) associée, le premier corps fluorescent (15a) et le deuxième corps fluorescent (15b) émettent de la lumière présentant des couleurs de lumière différentes et/ou des températures de couleur différentes.

6. Agencement de diodes électroluminescentes selon la revendication 5,
**caractérisé en ce que** la première diode électroluminescente (11a), au nombre d'au moins une, et la deuxième diode électroluminescente (11b), au nombre d'au moins une, font partie d'arrangements angulaires (40) différents ou de montages série (42) différents d'un même groupe de diodes électroluminescentes (25).

7. Agencement de diodes électroluminescentes selon la revendication 5 ou 6,
**caractérisé en ce que** le premier corps fluorescent (15a) de la première diode électroluminescente (11a), au nombre d'au moins une, et le deuxième corps fluorescent (15b) de la deuxième diode électroluminescente (11 b), au nombre d'au moins une, sont séparés optiquement l'un de l'autre.

8. Agencement de diodes électroluminescentes selon l'une des revendications précédentes,
**caractérisé en ce que** le support ou réflecteur (16) présente le contour d'un polygone régulier.

9. Agencement de diodes électroluminescentes (10) selon l'une des revendications précédentes,
comprenant un circuit imprimé (21) qui est relié au support ou réflecteur (16) et qui présente pour chaque groupe de diodes électroluminescentes (25) une zone de connexion (23) avec plusieurs pistes conductrices de connexion (24), sachant que chaque groupe de diodes électroluminescentes (25) est relié par des fils de liaison (28) aux pistes conductrices de connexion (24) dans la zone de connexion (23),
comprenant au moins deux pistes conductrices d'activation (26) sur le circuit imprimé (21), qui s'étendent autour des zones de connexion (23) et/ou autour du support ou réflecteur (16),
sachant qu'au moins une piste conductrice de connexion (24) de chaque zone de connexion (23) est reliée électriquement via un fil de liaison (28) à l'une des pistes conductrices d'activation (26).

10. Agencement de diodes électroluminescentes selon la revendication 9,
**caractérisé en ce que** les zones de connexion (23) sont disposées dans le voisinage direct du support ou réflecteur (16).

11. Agencement de diodes électroluminescentes selon la revendication 9 ou 10,
**caractérisé en ce que** le support ou réflecteur (16) présente le contour d'un polygone, sachant qu'une zone de connexion (23) est associée à chaque bord latéral (22) du support ou réflecteur (16).

12. Procédé de fabrication d'un agencement de diodes électroluminescentes (10), comprenant les étapes suivantes :
- préparation d'un circuit imprimé (21) comprenant un support ou réflecteur (16),
- préparation de puces de diode (12) comportant chacune une surface de contact d'anode (13) et une surface de contact de cathode (14), sachant que l'orientation de la puce de diode (12) autour de son axe vertical, disposé à angle droit par rapport au support ou réflecteur (16), est définie par un vecteur de direction (V) qui s'étend à angle droit par rapport à l'axe vertical de la puce de diode (12) et est une projection d'un vecteur s'étendant de la surface de contact d'anode (13) jusqu'à la surface de contact de cathode (14),
- mise en place des puces de diode (12) sur le support ou réflecteur (16), en plusieurs groupes de diodes électroluminescentes (25) comportant chacun plusieurs puces de diode (12), sachant que chaque groupe de diodes électroluminescentes (25) présente plusieurs arrangements angulaires (40) comportant chacun un nombre différent de puces de diode (12) qui sont disposées le long de deux droites qui se croisent et font partie d'au moins une ligne (41) coudée une seule fois, de telle sorte que le vecteur de direction (V) de la puce de diode médiane (12m), disposée sur une pointe ou le plus proche d'une pointe de la ligne coudée (41), est orienté à angle droit par rapport à une bissectrice (A) passant par la pointe de la ligne coudée (41), que soit les vecteurs de direction (V) de toutes les puces de diode (12) du même arrangement angulaire (40) ou du même groupe de diodes électroluminescentes (25) sont orientés de façon parallèle et/ou antiparallèle les uns par rapport aux autres, soit le vecteur de direction (V) de la puce de diode médiane (12m), disposée sur la pointe ou le plus proche de la pointe de la ligne coudée (41), au nombre d'au moins une, présente une orientation qui est différente de celle des vecteurs de direction (V) des autres puces de diode (12) du même arrangement angulaire (40),
- raccordement électrique des puces de diode (12) d'au moins deux arrangements angulaires (40), comportant respectivement des nombres différents de puces de diode (12), pour obtenir un montage série (42), de telle sorte que le groupe de diodes électroluminescentes (25) présente au moins deux montages série (42) qui présentent respectivement le même nombre de puces de diode (12).
